(19) Europäisches Patentamt
European Patent Office
Office européen des brevets

(11) **EP 2 592 663 B1**

(12) **FASCICULE DE BREVET EUROPEEN**

(45) Date de publication et mention
de la délivrance du brevet:
**18.06.2014 Bulletin 2014/25**

(51) Int Cl.:
***H01L 33/00*** *(2010.01)*   *H01L 27/15* *(2006.01)*

(21) Numéro de dépôt: **12191232.3**

(22) Date de dépôt: **05.11.2012**

(54) **Dispositif émetteur de lumière à transistors de type p et de type n tête-bêche, et procédé de fabrication**

Lichtemittierende Vorrichtung mit entgegengesetzten p-Typ und n-Typ Transistoren, und Herstellungsverfahren

Light-emitting device with head-to-tail p-type and n-type transistors, and manufacturing method

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.11.2011 FR 1160166**

(43) Date de publication de la demande:
**15.05.2013 Bulletin 2013/20**

(73) Titulaire: **Commissariat à l'Énergie Atomique et aux Énergies Alternatives 75015 Paris (FR)**

(72) Inventeurs:
• **Grenouillet, Laurent**
  **38140 RIVES (FR)**
• **Vinet, Maud**
  **38140 RIVES (FR)**

(74) Mandataire: **Ilgart, Jean-Christophe et al BREVALEX**
   **95, rue d'Amsterdam**
   **75378 Paris Cedex 8 (FR)**

(56) Documents cités:
   **US-A- 4 905 059     US-A1- 2005 247 924**

• **BATUDE P ET AL: "3D monolithic integration", CIRCUITS AND SYSTEMS (ISCAS), 2011 IEEE INTERNATIONAL SYMPOSIUM ON, IEEE, 15 mai 2011 (2011-05-15), pages 2233-2236, XP031998102, DOI: 10.1109/ISCAS.2011.5938045 ISBN: 978-1-4244-9473-6**

**Description**

**DOMAINE TECHNIQUE**

La présente invention se rapporte au domaine de la microélectronique et plus particulièrement des dispositifs microélectroniques émetteurs de rayonnement lumineux.

Elle concerne un dispositif émetteur de lumière permettant d'obtenir un flux lumineux variable sur une large gamme tout en ayant un agencement amélioré en particulier en termes d'encombrement.

**ART ANTÉRIEUR**

Il est bien connu de réaliser des diodes électroluminescentes formées par exemple d'une jonction P-N ou d'une jonction P-I-N.

Dans de tels dispositifs, des paires électrons/trous se recombinent dans une zone dite « de charge d'espace », de manière à créer des photons. Des hétéro-structures à puits quantiques peuvent être prévues dans la zone de charge d'espace, afin d'augmenter l'efficacité de recombinaison.

Un puits quantique peut être réalisé à l'aide d'un empilement de couches à base de matériaux semi-conducteurs de gaps différents, comprenant par exemple une couche à base d'un matériau de petit gap disposée entre deux couches de matériau de plus grand gap.

Il existe également des transistors électroluminescents, par exemple des transistors bipolaires N-P-N à hétérojonction tels que celui décrit dans le document US 7 297 589.

D'une manière générale, on cherche constamment à rendre les dispositifs microélectronique émetteurs de rayonnement lumineux les plus compacts possible, à pouvoir intégrer ces dispositifs sur des technologies connues, par exemple en technologie CMOS et, à ce que ces dispositifs permettent de traduire un signal électrique en information lumineuse le plus rapidement possible.

Le document US 4 905 059 A divulgue un dispositif microélectronique émetteur de rayonnement lumineux doté d'un premier et d'un deuxième transistor dont les grilles sont disposées en regard l'une de l'autre, de part et d'autre d'une zone de canal à base d'un matériau semi-conducteur non-dopé.

Les électrodes de source et de drain du premier transistor et du deuxième transistor sont toutes agencées dans un même plan et selon une disposition en croix de sorte que le flux de porteurs de charges, en particulier de trous, entre les électrodes de source et de drain du premier transistor croise et est orthogonal au flux de porteurs de charges, en particulier des électrons, entre les électrodes de source et de drain du deuxième transistor.

Un tel dispositif pose des problèmes d'encombrement, ainsi qu'une efficacité de recombinaison des porteurs de charges limitée.

**EXPOSÉ DE L'INVENTION**

La présente invention concerne un dispositif microélectronique émetteur de rayonnement lumineux comprenant au moins un premier transistor doté de zones de source et de drain formées dans au moins une première zone semi-conductrice dopée N et d'une grille, au moins un deuxième transistor doté de zones de source et de drain formées dans au moins une deuxième zone semi-conductrice dopée P et d'une grille, la grille du premier transistor et la grille du deuxième transistor étant disposées en regard l'une de l'autre, de part et d'autre d'une zone comprenant une région donnée à base d'au moins un matériau semi-conducteur intrinsèque et/ou non-dopé.

Les zones de source et de drain du premier transistor et du deuxième transistor sont prévues avec un agencement particulier de sorte qu'un premier axe passant par les zones de source et de drain du premier transistor, un deuxième axe passant par les zones de source et de drain du deuxième transistor, et un troisième axe passant par ladite région donnée, sont coplanaires et parallèles entre eux.

On peut ainsi mettre en oeuvre un premier flux d'un premier type de porteurs de charge, par exemple des trous circulant dans ladite région donnée et un deuxième flux de porteurs de charge d'un deuxième type circulant dans ladite région donnée suivant une même direction que celle du premier flux.

Cela peut permettre d'améliorer les recombinaisons entre porteurs de charges.

Un tel dispositif permet également de réaliser un réglage d'un courant de trous et d'un courant d'électrons de manière indépendante.

Dans une zone semi-conductrice, les électrons et les trous n'ont généralement pas la même faculté à se déplacer ou la même mobilité. Dans une diode électroluminescence, il n'y a qu'un seul courant qui circule, et donc le flux d'électrons est égal au flux de trous. Ces derniers, généralement plus lents à se déplacer, peuvent limiter le taux de recombinaison radiatif et donc le flux lumineux.

Selon l'invention, les flux d'électrons et de trous peuvent être réglés de manière indépendante par la manière dont ledit premier transistor et ledit deuxième transistor sont polarisés. Pour augmenter la mobilité des trous dans le dispositif, il est par exemple possible d'augmenter le courant généré dans le canal du deuxième transistor. On augmente ainsi le nombre de recombinaisons de paires électron/trou.

Un tel dispositif est compact tout en permettant d'obtenir un flux lumineux variable selon une gamme importante.

Un tel dispositif peut être réalisé par exemple en technologie CMOS.

La mise en oeuvre des transistors dans un tel dispositif diffère de celle d'une structure classique de transistor double grille notamment de par le dopage des zones de source et de drain.

Selon une possibilité de mise en oeuvre, les zones de source et de drain du premier transistor peuvent être situées dans un premier plan contenant ledit premier axe, les zones de source et de drain du deuxième transistor étant situées dans un deuxième plan contenant ledit deuxième axe, ledit deuxième plan étant distinct dudit premier plan et parallèle audit premier plan, une zone de source du premier transistor étant disposée en regard d'une zone de source ou de drain du deuxième transistor.

Selon une variante, les zones de source et de drain du premier transistor peuvent être situées dans un même plan que les zones de source et de drain du deuxième transistor.

Selon une possibilité de mise en oeuvre, le dispositif peut être agencé de sorte que la zone de source du premier transistor est disposée en regard de la zone de source du deuxième transistor, la zone de drain du premier transistor étant disposée en regard de la zone de drain du deuxième transistor.

On peut ainsi mettre en oeuvre des flux de porteurs de charge de types différents ayant une même direction mais des sens opposés dans la région donnée située entre les grilles du premier et deuxième transistor.

Selon une possibilité de mise en oeuvre, le premier transistor et le deuxième transistor peuvent être symétriques par rapport à un plan passant par ladite région donnée.

Selon une possibilité de mise en oeuvre, ladite région donnée semi-conductrice peut comprendre un matériau à gap direct.

La mise en oeuvre de la région donnée à l'aide d'un tel matériau peut permettre d'obtenir un meilleur rendement en termes de photoémission.

Selon une possibilité de mise en oeuvre, ladite région donnée peut être formée d'une hétéro-structure comportant un empilement d'au moins un premier matériau semi-conducteur, d'au moins un deuxième matériau semi-conducteur de gap différent de celui du premier matériau semi-conducteur ou d'un empilement formé d'au moins un premier matériau semi-conducteur, d'au moins un deuxième matériau semi-conducteur et d'au moins un troisième matériau semi-conducteur, le deuxième matériau semi-conducteur étant situé entre le premier matériau semi-conducteur et le troisième matériau semi-conducteur et ayant un gap plus faible que celui desdits premier et troisième matériaux semi-conducteurs.

Cela peut permettre d'obtenir un meilleur confinement des porteurs dans la région donnée. Cela peut également permettre de localiser les porteurs dans une zone où auront lieu les recombinaisons.

Selon une possibilité de mise en oeuvre du dispositif, la zone de source du premier transistor peut être disposée en regard et séparée d'une zone de source ou de drain du deuxième transistor par au moins une zone isolante, la zone de drain du premier transistor étant en regard et séparée d'une zone de source ou de drain du deuxième transistor par au moins une autre zone isolante. Ces zones isolantes peuvent permettre de mettre en oeuvre une polarisation du premier transistor indépendante de celle du deuxième transistor.

Ladite région donnée peut avoir une épaisseur comprise entre 2 nm et 100 nm.

La présente invention concerne également un procédé de réalisation d'un dispositif tel que défini plus haut.

La présente invention concerne également un procédé de réalisation d'un dispositif microélectronique émetteur de rayonnement lumineux comprenant dans cet ordre ou dans un ordre différent, des étapes de :

- réalisation d'au moins un premier transistor reposant sur un premier substrat, le premier substrat comprenant une couche de support, une couche isolante et une fine couche semi-conductrice, le premier transistor étant doté de zones de source et de drain formées dans au moins une première zone semi-conductrice dopée N et d'une grille,
- formation d'au moins un deuxième transistor reposant sur un deuxième substrat, le deuxième substrat comprenant une couche de support, une couche isolante, et une fine couche semi-conductrice, le deuxième transistor étant doté de zones de source et de drain formées dans au moins une deuxième zone semi-conductrice dopée P et d'une grille,
- retrait de la couche de support et de ladite couche isolante d'un substrat donné parmi le premier substrat et le deuxième substrat,
- retrait de la couche de support et d'au moins une portion donnée de la couche isolante de l'autre substrat parmi le premier substrat et le deuxième substrat, ladite portion donnée étant retirée de manière à dévoiler la fine couche semi-conductrice en regard d'une grille d'un transistor donné parmi ledit premier transistor et le deuxième transistor,
- assemblage de la fine couche semi-conductrice dudit substrat donné avec ladite fine couche semi-conductrice dudit autre substrat ou avec un matériau semi-conducteur donné formé sur ladite fine couche semi-conductrice dudit autre substrat, le premier transistor étant placé en regard du deuxième transistor.

Le retrait de ladite portion donnée peut être effectué de manière à former une ouverture dans la couche isolante dévoilant la fine couche semi-conductrice en regard d'une grille d'un transistor donné parmi ledit premier transistor et le deuxième transistor, le procédé comprenant préalablement à l'étape de retrait de la couche de support et de ladite couche isolante d'un substrat donné parmi le premier substrat et le deuxième substrat, la croissance dudit matériau semi-conducteur donné sur ladite fine couche semi-conductrice dudit autre substrat de manière à recouvrir la couche isolante dudit autre substrat.

Le matériau semi-conducteur donné peut être un matériau à gap direct.

Selon une possibilité de mise en oeuvre, ledit matériau semi-conducteur donné peut être un matériau ayant un gap plus faible que le matériau de ladite fine couche semi-conductrice du premier substrat et/ou du matériau de la fine couche semi-conductrice du deuxième substrat.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- les figures 1, 2A, 2B, 2C illustrent des exemples de dispositifs microélectroniques émetteurs de rayonnement lumineux suivant l'invention, comprenant deux transistors dont les grilles respectives sont symétriques et disposées tête bêche par rapport à une zone semi-conductrice intrinsèque et/ou non-dopée,
- les figures 3, 4, et 5 illustrent des structures de bande dans une zone semi-conductrice disposée entre les grilles des transistors d'un dispositif microélectronique émetteur de rayonnement lumineux suivant l'invention,
- la figure 6 illustre un exemple de dispositif microélectronique émetteur de rayonnement lumineux suivant l'invention, comprenant un matériau à gap direct entre les grilles de ses deux transistors disposés l'un en regard de l'autre de manière symétrique et tête bêche l'un par rapport à l'autre,
- la figure 7 illustre un exemple de dispositif microélectronique émetteur de rayonnement lumineux suivant l'invention formé de deux transistors disposés l'un en regard de l'autre de manière symétrique et tête bêche l'un par rapport à l'autre, les zones de source et de drain du premier transistor étant isolées des zones de sources et de drain du deuxième transistor par l'intermédiaire de zones isolantes,
- les figures 8A-8C, 9A-9C, 10A-10C illustrent un premier exemple de procédé de réalisation d'un dispositif microélectronique suivant l'invention,
- les figures 11A-11C illustrent un deuxième exemple de procédé de réalisation d'un dispositif microélectronique suivant l'invention,
- les figures 12A-12C illustrent un exemple de dispositif microélectronique émetteur de rayonnement lumineux suivant l'invention, comprenant deux transistors dont les grilles respectives sont symétriques par rapport à une zone semi-conductrice sous forme d'un barreau semi-conducteur,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

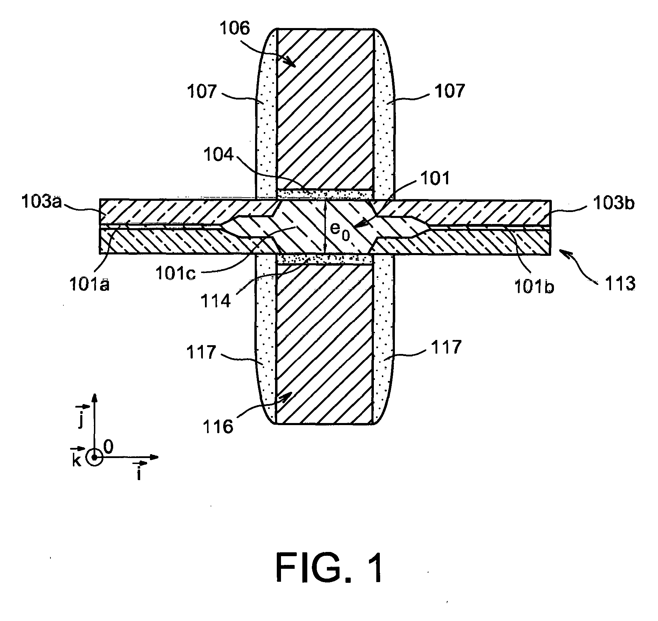

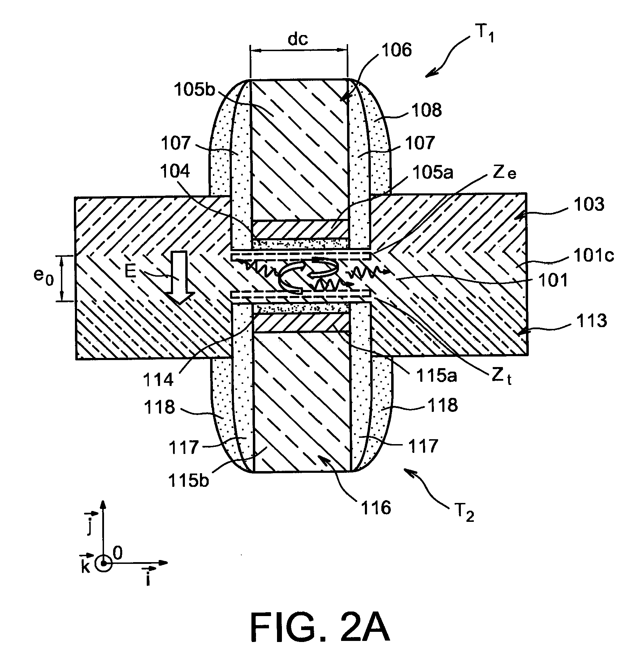

Un premier exemple de dispositif microélectronique émetteur de rayonnement lumineux suivant l'invention est illustré sur les figures 1, 2A-2C.

Ce dispositif est formé d'un premier transistor $T_1$, dont les zones de source et de drain sont formées dans une zone 103 à base d'un matériau semi-conducteur et sont dopées selon un dopage de type N, et d'un deuxième transistor $T_2$, dont les zones de source et de drain sont formées dans une zone 113 à base d'un matériau semi-conducteur et sont dopées selon un dopage de type P.

Dans cet exemple, les zones 103, 113 respectivement de type N et de type P, sont disposées de part et d'autre d'une zone 101 semi-conductrice non-dopée à base d'un matériau semi-conducteur intrinsèque.

Le premier transistor $T_1$ et le deuxième transistor $T_2$ sont disposés en regard l'un de l'autre avec des grilles respectives 106, 116 disposées tête bêches l'une par rapport à l'autre.

Le premier transistor $T_1$ et le deuxième transistor $T_2$ sont positionnés de manière symétrique par rapport au plan principal de la zone semi-conductrice 101 (le plan principal étant parallèle au plan $[O; \vec{i}; \overline{k}]$ du repère orthogonal $[O; \vec{i}; \vec{j}; \overline{k}]$ défini sur les figures 1 et 2A) disposée entre les deux transistors $T_1$, $T_2$, la grille 106 du premier transistor $T_1$ étant située en regard de la grille 116 du deuxième transistor $T_2$ (figures 1 et 2A).

Dans l'exemple de réalisation donné sur les figures 1, 2A-2C, la zone 101 disposée entre les zones actives 103, 113 et les grilles 106, 116 des transistors $T_1$, $T_2$ peut être entièrement semi-conductrice et non-dopée et/ou à base d'un matériau semi-conducteur intrinsèque.

Cette zone 101 comporte une région 101a de matériau semi-conducteur située entre la zone de source 103a du premier transistor $T_1$ et une zone de source ou de drain du deuxième transistor $T_2$, ainsi qu'une région 101b de matériau semi-conducteur située entre la zone de drain 103b du premier transistor $T_1$ et une zone de drain ou de source du deuxième transistor $T_2$.

Selon une mise en oeuvre particulière, les régions 101a, 101b de la zone 101 peuvent éventuellement avoir une épaisseur nulle.

Les régions 101a et 101b peuvent avoir une épaisseur (mesurée dans une direction parallèle au vecteur $\vec{j}$ du repère orthogonal $[O;\vec{i};\vec{j};\vec{k}]$ défini sur les figures 1, 2A-2C) comprise par exemple entre 0 et 50 nm.

Dans une région située entre les grilles 106, 116, et en particulier dans la région donnée 101c de la zone semi-conductrice 101 de matériau semi-conducteur intrinsèque située entre les grilles 106, 116 et entre les régions 101a et 101b, des paires électrons trous sont susceptibles de se recombiner de manière radiative lorsque les transistors sont à l'état passant ou « ON » et qu'un courant passe entre la source et le drain d'un même transistor.

La région 101c, et dans cet exemple toute la zone semi-conductrice 101, peut être à base de Si intrinsèque.

De préférence, les zones dopées N et dopées P ne s'étendent pas entre les grilles 106 et 116 du premier transistor $T_1$ et du deuxième transistor $T_2$.

La zone semi-conductrice 101, et en particulier la région 101c de cette zone 101 peut être prévue avec une épaisseur $e_0$ (mesurée dans une direction parallèle au vecteur $\vec{j}$ du repère orthogonal $[O;\vec{i};\vec{j};\vec{k}]$) par exemple de l'ordre de 10 nm ou comprise par exemple entre une valeur min par exemple de l'ordre de 3 nm et une valeur $e_{max}$ par exemple de l'ordre de 100 nm.

L'épaisseur $e_0$ peut être prévue avec une valeur minimale $e_{min}$ permettant d'obtenir une inversion c'est à dire avoir un canal d'électrons sur une zone que l'on appellera « face avant » de la région 101c de la zone semi-conductrice et qui est située à proximité de la grille 106 du premier transistor. $T_1$, et avoir une accumulation sur une zone que l'on appellera « face arrière » de la région 101c de la zone semi-conductrice 101 et qui est située à proximité de la grille 116 du deuxième transistor $T_2$, en particulier lorsque la région 101c est non dopée et a été formée à partir d'une plaque comportant un matériau semi-conducteur intrinsèque et/ou ayant un dopage résiduel de type P.

Les termes d'inversion et d'accumulation s'entendent ici par rapport à un substrat de Si référence non-dopé ou comportant un dopage résiduel de type P. Dans le cas où le substrat de départ est réellement non dopé, on peut avoir une couche d'inversion d'électron en face avant et une couche d'inversion de trous en face arrière.

Pour cela, par exemple dans le cas où la région 101 est à base de Si, l'épaisseur $e_{min}$, encore appelée épaisseur critique et notée $T^*_{Si}$ peut être définie par exemple à l'aide de la formule suivante lorsque la tension Vg2 appliquée sur la face avant du transistor est plus grande que la tension de seuil de la face avant lorsque la face avant est inversée :

$$T^*_{SI} = \frac{k\,T}{q}\,\frac{\epsilon_{SI}}{C_{BOX}(V_{FB2} - V_{G2})}\,\ln\left[\frac{N_a C_{OX} C_{BOX}(V_{FB2} - V_{G2})}{q\epsilon_{SI}n_i^2}\right].$$

Avec k la constante de Boltzmann, T la température, $\epsilon_{si}$ la constante diélectrique du silicium, Cox et Cbox, les capacités d'oxyde du transistor NMOS et du transistor PMOS respectivement et Vfb2 et Vg2 les tensions de bande plate et de grille appliquées sur le transistor PMOS.

La valeur maximale $e_{max}$ est celle à laquelle l'épaisseur $e_0$ peut être prévue de sorte qu'à un point du canal, les électrons et les trous sont éloignés de moins que le rayon de Bohr d'un exciton. Pour la plupart des matériaux semi-conducteurs, le rayon de Bohr de l'exciton est de l'ordre d'une dizaine de nanomètres.

Les zones de source et de drain du premier transistor sont chacune en regard d'une zone de source ou de drain du deuxième transistor et sont situées dans un même plan, ce plan étant différent de celui dans lequel les zones de source et de drain du deuxième transistor sont disposées et étant parallèle à celui dans lequel les zones de source et de drain du deuxième transistor sont disposées.

Les zones de sources et de drain du premier transistor et du deuxième transistor sont en particulier agencées de sorte qu'un premier axe X'X passant par les zones de source et de drain du premier transistor et parallèle au canal du premier et du deuxième transistor est coplanaire et parallèle avec un deuxième axe Y'Y passant par les zones de source et de drain du deuxième transistor, le premier axe X'X, le deuxième axe Y'Y, ainsi qu'un troisième axe Z'Z passant par la région donnée 101c étant coplanaires et parallèles.

Avec une telle disposition des zones de source et de drain, le flux de porteurs de charges circulant entre la zone de source et de drain du premier transistor et pris dans la région 101c, a une même direction ou une direction parallèle à celle du flux de porteurs de charges circulant entre la zone de source et de drain du deuxième transistor et pris dans la région 101c, ce qui permet d'améliorer les recombinaisons de porteurs et par conséquent l'efficacité d'émission de photons.

Les grilles 106, et 116 appartenant respectivement au premier transistor $T_1$ et au deuxième transistor $T_2$ sont séparées entre elles par un empilement comprenant : une zone de diélectrique 104 de grille, la région 101c de la zone semi-conductrice intrinsèque 101, une deuxième zone de diélectrique 114 de grille.

Les grilles 106 et 116 peuvent être prévues avec une longueur également appelée dimension critique de (mesurée dans une direction parallèle au vecteur $\vec{i}$ du repère orthogonal $[O;\vec{i};\vec{j};\vec{k}]$) comprise par exemple entre 10 nm et 10 $\mu$m, par exemple de l'ordre de 100 nm.

Les zones de diélectrique 104 et 114 de grille peuvent être par exemple à base de $SiO_2$, ou de $HfO_2$, ou de HfSiON.

Les grilles 106, 116 peuvent être formées par exemple d'un bloc semi-conducteur, par exemple en polysilicium (figure 1) ou éventuellement être formées (figures 2A-2C) d'un empilement de plusieurs blocs 105a-105b, 115a-115b.

Dans ce cas, les grilles 106, 116 peuvent être formées par exemple d'un premier bloc 105a, 115a à base de métal tel que par exemple du nitrure de titane ou du nitrure de tantale, et d'un deuxième bloc 105b, 115b recouvrant le premier bloc et par exemple à base de polysilicium, ce afin d'ajuster les propriétés de travail de sortie, et de résistivité respectives des grilles 106, 116.

Les grilles 106, 116 sont chacune entourées de part et d'autre de zones isolantes formant des espaceurs. Des zones isolantes 107 partiellement enterrées dans la zone semi-conductrice 103 du premier transistor $T_1$ peuvent être prévues contre des flancs de la première électrode de grille 106, tandis que des zones isolantes 117 partiellement enterrées dans la zone semi-conductrice 113 du deuxième transistor $T_2$ peuvent être prévues contre des flancs de la deuxième électrode de grille 116.

Les zones de sources et drains peuvent être éventuellement surélevées par rapport à la couche semi-conductrice du canal.

Selon une possibilité de mise en oeuvre illustrée sur les figures 2A-2C, les transistors $T_1$ et $T_2$ peuvent être munis également d'autres zones isolantes 108, 118 respectivement contre les zones isolantes 107 et 117.

Sur l'exemple de réalisation de la figure 2A, des zones Ze et Zt dans lesquelles des électrons et des trous sont respectivement destinés à être canalisés sont illustrées dans le cas où un champ transverse E est généré par une polarisation adéquate des zones de source et de drain, ainsi que des grilles 106, 116 des transistors $T_1$ et $T_2$.

En adaptant les polarisations de source et de drain des transistors $T_1$ et $T_2$, ces zones Ze et Zt d'électrons et de trous sont créées par effet de champ. et rendent les recombinaisons électrons-trous possibles de manière à créer des photons au sein d'un même canal partagé par les deux transistors $T_1$ et $T_2$.

On peut placer le dispositif en mode dit de « faible inversion », par exemple en polarisant la grille du premier transistor $T_1$ avec un potentiel positif supérieur et proche de sa tension de seuil, et en polarisant la grille du deuxième transistor $T_2$ avec un potentiel négatif et proche de sa tension de seuil, les zones d'inversion étant les plus éloignées possibles des grilles 106, 116.

On peut également et de préférence se placer dans des conditions de polarisation pour lesquelles, à un point du canal, les électrons et les trous sont éloignés de moins que le rayon de Bohr d'un exciton.

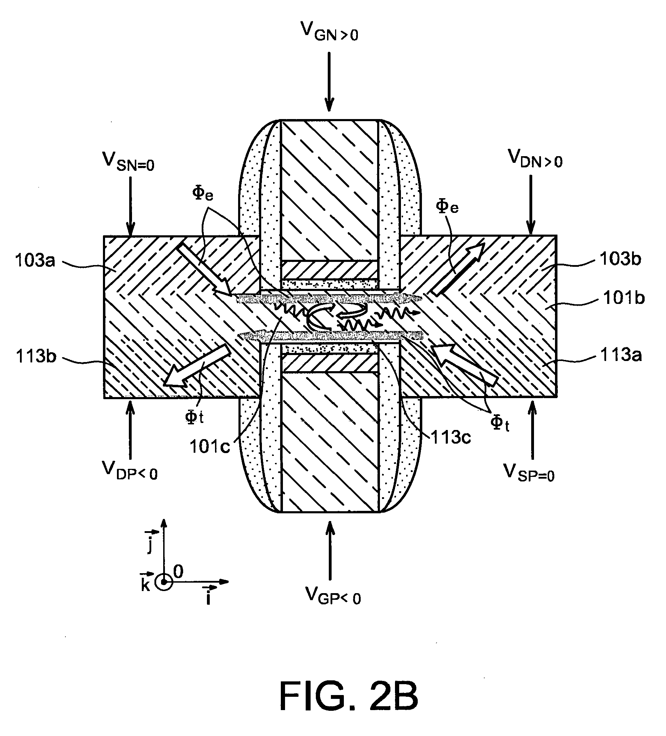

Sur l'exemple de réalisation de la figure 2B, le dispositif microélectronique émetteur de rayonnement lumineux est agencé de sorte que la zone de source 103a du premier transistor $T_1$ est disposée en regard de la zone de drain 113b du deuxième transistor $T_2$, tandis que la zone de drain 103b du premier transistor $T_1$ et la zone de source 113a du deuxième transistor $T_2$ sont disposées en regard l'une de l'autre.

Un flux d'électrons $\Phi e$ de la source 103a vers le drain 103b du premier transistor $T_1$ est illustré sur la figure 2B par une première suite de flèches, tandis qu'un flux de trous $\Phi t$ (illustré par une deuxième suite de flèches $\Phi t$) opposé au flux $\Phi e$ se dirige de la source 113a vers le drain 113b du deuxième transistor $T_2$.

Dans la région 101c située entre les grilles 106, 116, de matériau semi-conducteur intrinsèque, les flux $\Phi t$ et $\Phi e$ ont une même direction et des sens opposés.

Pour générer le flux d'électrons $\Phi e$, la polarisation du premier transistor $T_1$ peut être telle que sa source 103a est mise par exemple à un potentiel $V_{SN} = 0$, tandis que sa grille 106 est mise par exemple à un potentiel $V_{GN} > 0$, et que son drain 103b est mis par exemple à un potentiel $V_{DN} > 0$.

Pour générer le flux de trous $\Phi t$, la polarisation du deuxième transistor $T_2$ peut être telle que sa source 113a est mise par exemple à un potentiel $V_{SP} = 0$ (ou supérieur à 0), tandis que sa grille 116 est mise par exemple à un potentiel $V_{GP} < 0$ (ou égal à 0, respectivement), et que son drain 113b est mis par exemple à un potentiel $V_{DP} < 0$.

Le flux de trous $\Phi t$ et le flux d'électrons $\Phi e$ peuvent être modulés indépendamment l'un de l'autre.

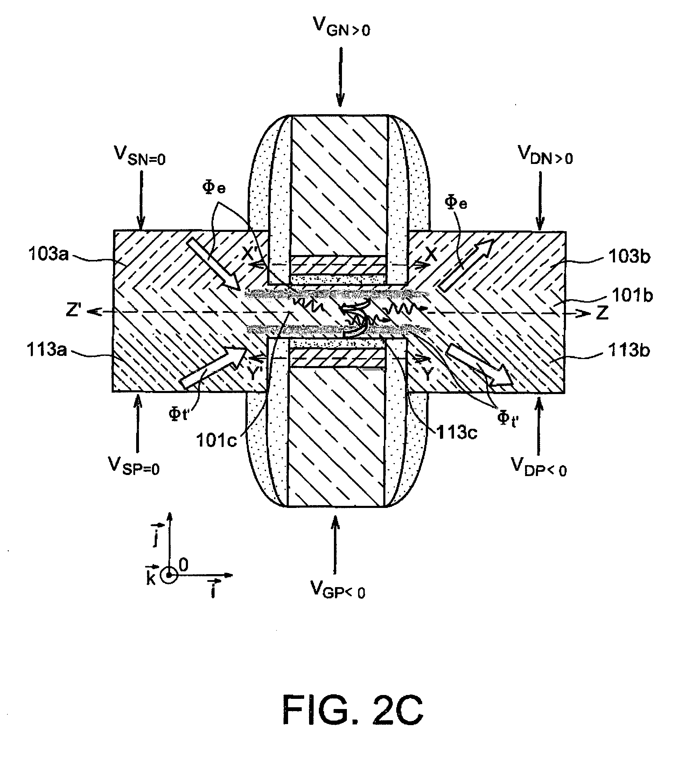

Un autre mode de réalisation du dispositif microélectronique émetteur de rayonnement lumineux suivant l'invendon est illustré sur la figure 2C.

Le dispositif émetteur de rayonnement lumineux est dans cet exemple agencé de sorte que la zone de source 103a du premier transistor $T_1$ est disposée en regard de la zone de source 113a du deuxième transistor $T_2$, tandis que la zone de drain 103b du premier transistor $T_1$ et la zone de drain 113b du deuxième transistor $T_2$ sont disposées en regard l'une de l'autre.

De cette manière, des flux d'électrons et de trous de même sens peuvent être générés (un flux d'électrons de la source 103a vers le drain 103b du premier transistor $T_1$ étant indiqué sur la figure 2C par une première suite de flèches $\Phi_e$, tandis qu'un flux de trous de la source 113a vers le drain 113b du deuxième transistor $T_2$ est indiqué par une deuxième suite de flèches $\Phi_{t'}$.

Dans la région 101c située entre les grilles 106, 116, de matériau semi-conducteur intrinsèque, des flux $\Phi_t$ et $\Phi_e$ de même direction et de même sens sont ainsi mis en oeuvre.

Pour générer le flux d'électrons $\Phi_e$, la polarisation du premier transistor $T_1$ peut être telle que sa source 103a est mise par exemple à un potentiel $V_{SN} = 0$, tandis que sa grille 106 est mise par exemple à un potentiel $V_{GN} > 0$, et que son drain 103b est mis par exemple à un potentiel $V_{DN} > 0$. Pour générer le flux de trous $\Phi_{t'}$ la polarisation du deuxième transistor $T_2$ peut être telle que sa source 113a est mise par exemple à un potentiel $V_{SP} = 0$, tandis que sa grille 116 est mise par exemple à un potentiel $V_{GP} < 0$, et que son drain 113b est mis par exemple à un potentiel $V_{DP} < 0$.

Avec un tel dispositif, on peut régler indépendamment un courant de trous et un courant d'électrons en fonction des polarisations respectives du premier transistor $T_1$ et du deuxième transistor $T_2$.

Une modulation contrôlée du courant d'électrons par le transistor NMOS et du courant de trous par le transistor PMOS peut être réalisée sur plusieurs ordres de grandeur de manière à contrôler le flux lumineux dans une gamme importante.

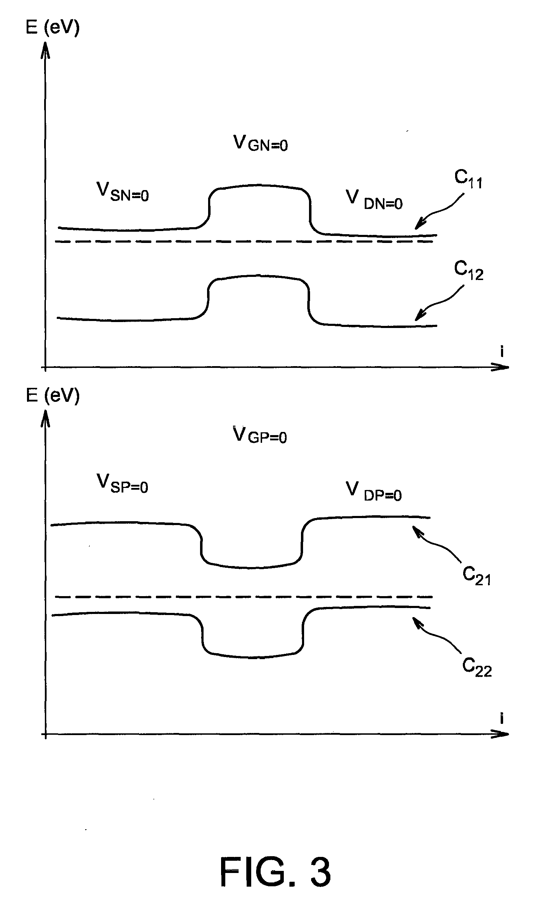

Sur la figure 3, des courbes $C_{11}$, $C_{12}$ représentatives de structures de bande (bande de conduction $E_c$ pour $C_{11}$, bande de valence $E_v$ pour $C_{12}$) d'une zone de canal du premier transistor $T_1$ dans la direction de la longueur de cette zone de canal (c'est à dire dans une direction parallèle au vecteur $\vec{i}$ du repère orthogonal $[O; \vec{i} : \vec{j}; \vec{k}]$) lorsque le premier transistor $T_1$ n'est pas polarisé et $V_{SN} = 0$, $V_{GN}$ 0, et $V_{DN} = 0$, sont données.

Des courbes $C_{21}$, $C_{22}$ représentent sur cette figure des structures de bande (bande de conduction $E_c$ pour $C_{21}$, bande de valence $E_v$ pour $C_{22}$) d'une zone de canal du deuxième transistor $T_2$ selon la direction de sa longueur (c'est à dire dans une direction parallèle au vecteur $\vec{i}$ du repère orthogonal $[O; \vec{i}; \vec{j}; \vec{k}]$) lorsque le deuxième transistor $T_2$ n'est pas polarisé et $V_{SP} = 0$, $V_{GP} = 0$, et $V_{DP} = 0$.

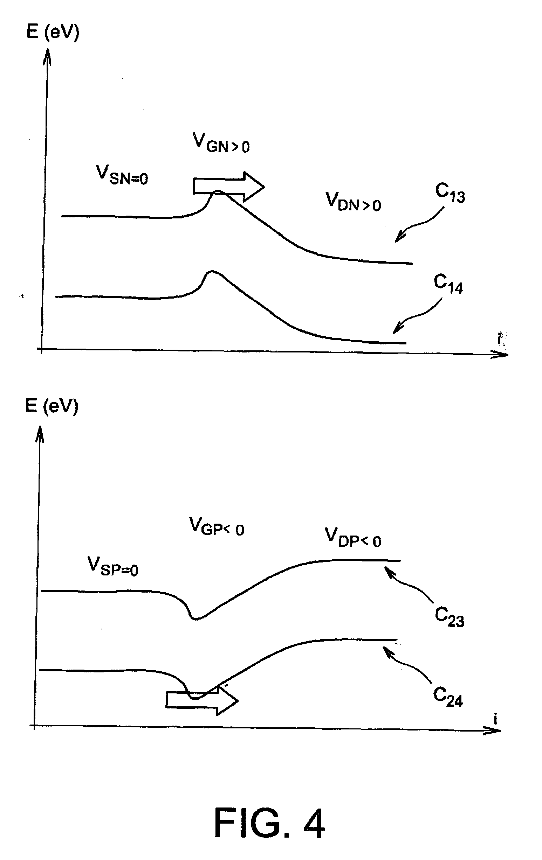

Sur la figure 4, des courbes $C_{13}$, $C_{14}$ représentatives de structures de bande d'une zone de canal du premier transistor $T_1$ dans la direction de la longueur de cette zone de canal (c'est à dire dans une direction parallèle au vecteur $\vec{i}$ du repère orthogonal $[O; \vec{i}; \vec{j}; \vec{k}]$) lorsque le premier transistor $T_1$ est polarisé avec des tensions de polarisation comprises entre 0 et 5V, telles que $V_{SN} = 0$, $V_{GN} > 0$, et $V_{DN} > 0$, sont données.

Des courbes $C_{23}$, $C_{24}$ représentent sur cette figure des structures de bande d'une zone de canal du deuxième transistor $T_2$ selon la direction de sa longueur (c'est à dire dans une direction parallèle au vecteur $\vec{i}$ du repère orthogonal $[O; \vec{i}; \vec{j}; \vec{k}]$) lorsque le deuxième transistor $T_2$ avec des tensions de polarisation comprises en valeur absolue entre 0 et 5V, telles que $V_{SP} = 0$, $V_{GP} < 0$, et $V_{DP} < 0$, sont également données.

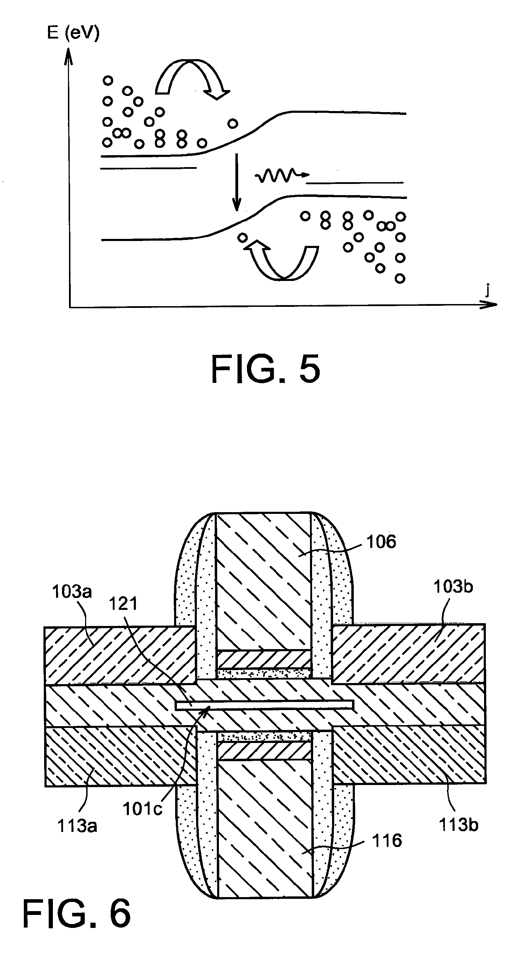

Sur la figure 5, une structure de bande de la zone de canal commun située entre les grilles 106 et 116 des transistors $T_1$, et $T_2$ selon une direction verticale (c'est à dire dans une direction parallèle au vecteur $\vec{j}$ du repère orthogonal $[O; \vec{i}; \vec{j}; \vec{k}]$) illustre notamment la pseudo jonction P-N ou P-I-N créée dans cette zone ainsi que le phénomène de recombinaisons radiatives entre des électrons de la zone de canal peuplée d'électrons et la zone de canal peuplée de trous.

Selon une possibilité de mise en oeuvre du dispositif microélectronique suivant l'invention illustrée sur la figure 6, la zone semi-conductrice 101 et en particulier la région semi-conductrice 101c de cette zone 101 disposée entre les grilles 106, 116 peut être formée à base d'un matériau semi-conducteur à gap direct ou comprendre un matériau semi-conducteur à gap direct, par exemple un matériau III-V tel que par exemple du InGaAs ou du InGaAsP ou du InGaN ou un matériau II-VI tel que par exemple du CdHgTe ou encore de boîtes quantiques semi-conductrices (« quantum dots » selon la terminologie anglo-saxonne). La mise en oeuvre d'une telle région 101c peut permettre d'obtenir un meilleur rendement en termes de photoémission.

La région 101c située entre les grilles 106, 116 peut être éventuellement formée d'un empilement de plusieurs couches semi-conductrices, par exemple d'une couche de Si et d'une couche de SiGe, ou par exemple d'un empilement Si/InP ou d'un empilement InP/InGaAs ou d'un empilement InGaAs avec différentes compositions d'In et de Ga. Le choix des matériaux de la région 101c dépend notamment de la longueur d'onde que l'on souhaite émettre.

Selon une possibilité de mise en oeuvre (figure 6), la région semi-conductrice 101c disposée entre les grilles des transistors $T_1$ et $T_2$ peut être prévue de sorte qu'elle est formée d'une hétéro-structure comportant un empilement 121 d'au moins un premier matériau semi-conducteur, d'au moins un deuxième matériau semi-conducteur, et d'au moins un troisième matériau semiconducteur, le deuxième matériau semiconducteur étant situé entre le premier matériau semi-conducteur et le troisième matériau semi-conducteur et ayant un gap plus faible que celui desdits premier et troisième matériaux semi-conducteurs. Le premier matériau semi-conducteur peut être par exemple du $In_xGa_{1-x}As$, le deuxième matériau semi-conducteur peut être par exemple du $In_xGa_{1-x}As_{1-y}P_y$, tandis que le troisième matériau semi-conducteur peut être par exemple du $in_xGa_{1-x}As$.

L'un ou l'autre des empilements suivants: $In_xGa_{1-x}As/In_yGa_{1-y}As/In_xGa_{1-x}As$ avec y>x, ou $In_xGa_{1-x}As/In_xGa_{1-x}As_{1-y}P_y/In_xGa_{1-x}As$ ou $Si/Si_{1-x}Ge_x/Si$, ou Si/nanocristaux à base de SI/SI ou $CdTe/Cd_{1-x}Hg_xTe/CdTe$, peuvent être également mis en oeuvre.

La mise en oeuvre d'une telle région 101c peut permettre d'obtenir un meilleur confinement des porteurs dans la région 101c. Cela peut également permettre de localiser les porteurs dans une zone où auront lieu les recombinaisons.

Selon une variante, la région semi-conductrice 101c disposée entre les grilles des transistors $T_1$ et $T_2$ peut être prévue de sorte qu'elle est formée d'une hétéro-structure comportant un empilement d'au moins un premier matériau semi-conducteur tel que du silicium, et d'au moins un deuxième matériau semi-conducteur tel que par exemple du SiGe, ayant un gap plus faible que celui du matériau semi-conducteur.

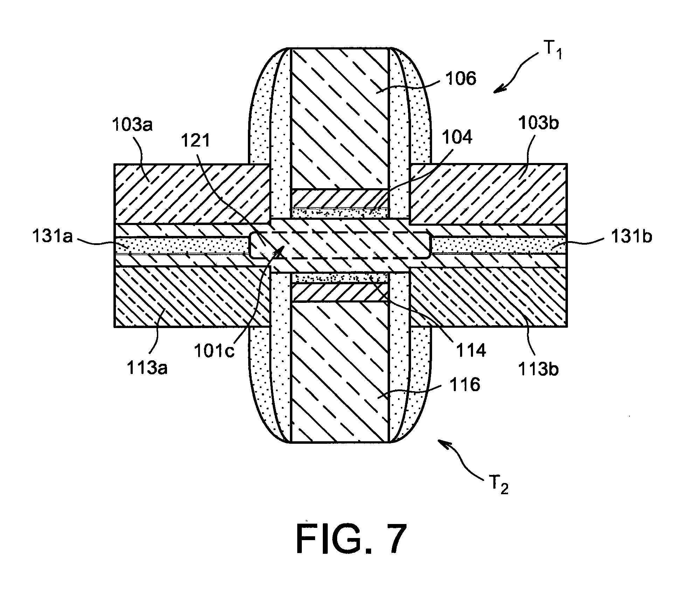

Une variante du dispositif microélectronique émetteur de rayonnement lumineux qui vient d'être décrit est donnée sur la figure 7.

Pour cette variante, des zones isolantes 131a, 131b sont prévues entre les zones semi-conductrices 103 et 113.

Ces zones isolantes 131a, 131b, sont disposées de part et d'autre de la région 101c de matériau semi-conducteur intrinsèque située entre les grilles 106, 116 des transistors $T_1$, $T_2$ et qui peut être par exemple à base d'un matériau semi-conducteur à gap direct.

Une première zone isolante 131a est prévue entre une zone de source 103a du premier transistor $T_L$ et une autre zone, de source ou de drain, du deuxième transistor $T_2$ et qui est située en regard de la zone de source 103a du premier transistor $T_1$. Une deuxième zone isolante 131b est disposée quant à elle entre une zone de drain 103b du premier transistor $T_1$, et une autre zone de drain ou de source de l'autre des transistors.

Pour cette variante de réalisation, la commande du transistor peut être avantageusement dé- corrélée de celle de la jonction PIN.

Selon une mise en oeuvre particulière du dispositif suivant l'invention, celui-ci peut être également soumis à un mode de polarisation pulsé permettant de moduler la position des porteurs, en appliquant par exemple une tension variable sur la grille des transistors, la fréquence de cette tension alternative pouvant être comprise par exemple entre 10 Hz et 1 GHz.

Un tel mode de réalisation peut être utile notamment quand l'épaisseur du canal est faible, et qu'il est difficile de créer de manière permanente et simultanée deux couches d'inversion.

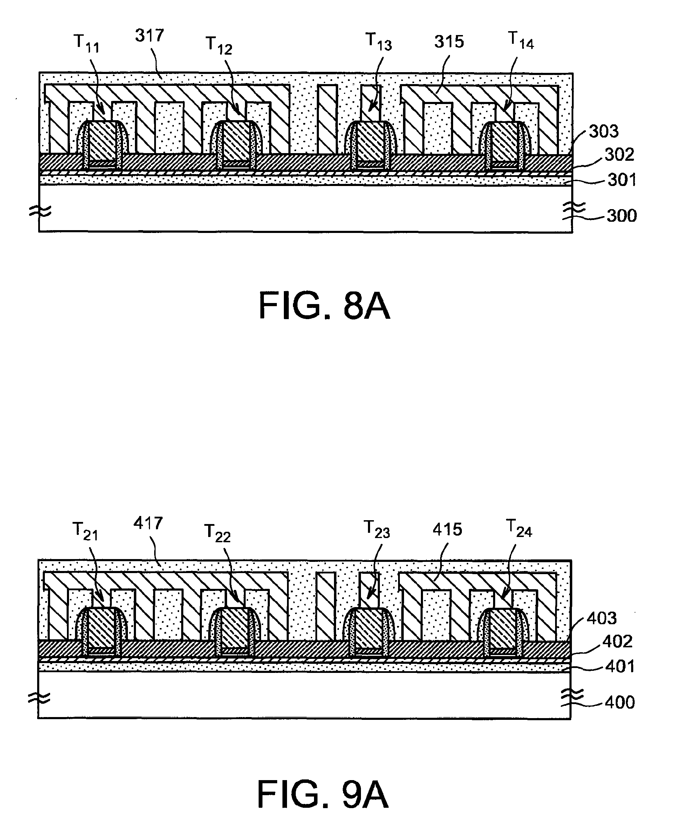

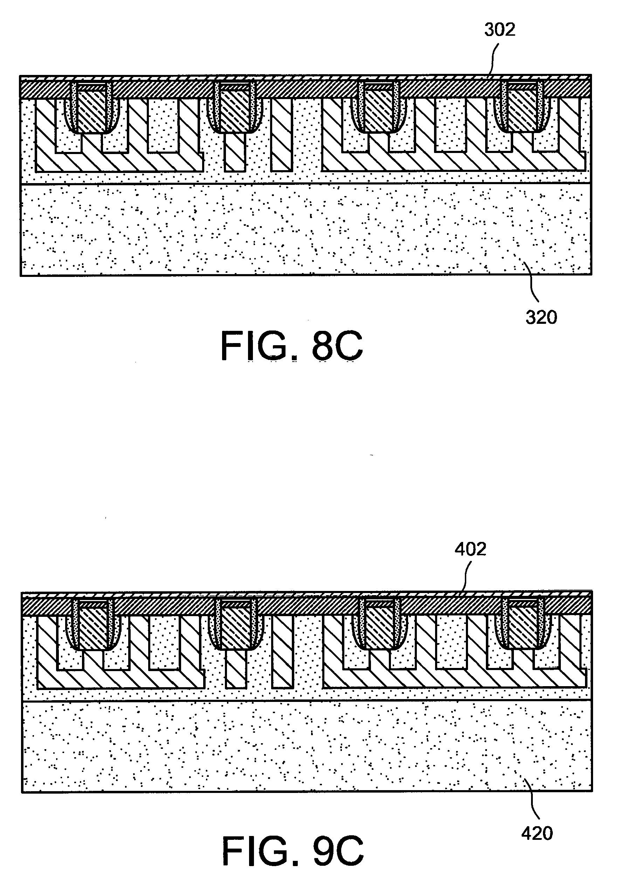

Un exemple de procédé de réalisation d'un dispositif émetteur de rayonnement lumineux suivant l'invention et du type de celui précédemment décrit en liaison avec les figures 1, 2A-2C, va à présent être donné en liaison avec les figures 8A-8C, 9A-9C, et 10A-10C.

On réalise tout d'abord un ou plusieurs transistors $T_{11}$, $T_{12}$, $T_{13}$, $T_{14}$ sur un premier substrat de type semiconducteur sur isolant, par exemple de type SOI (SOI pour « Silicon on Insulator » ou silicium sur isolant) comprenant une couche de support 300 sacrificielle, une fine couche isolante 301 reposant sur la couche de support 300, et une fine couche semi-conductrice 302 reposant sur la couche isolante 301.

Les transistors $T_{11}$, $T_{12}$, $T_{13}$, $T_{14}$ ont des zones de source et de drain formées dans une zone 303 à base d'un matériau semi-conducteur dopé selon un dopage de type N. Cette zone 303 dopée N peut être réalisée sur la fine couche semi-conductrice 302, qui peut être quant à elle non dopée ou à base d'un matériau semi-conducteur intrinsèque (figure 8A).

On réalise également un ou plusieurs transistors $T_{21}$, $T_{22}$, $T_{23}$. $T_{24}$, sur un deuxième substrat de type semiconducteur sur isolant, par exemple de type SOI, comprenant une couche de support 400 sacrificielle, une fine couche isolante 401 reposant sur la couche de support 400, et une fine couche semi-conductrice 402 reposant sur la couche isolante 401. La fine couche semi-conductrice 402. Les transistors $T_{21}$, $T_{22}$, $T_{23}$, $T_{24}$ ont des zones de source et de drain formées dans une zone 403 à base d'un matériau semi-conducteur dopé selon un dopage de type P. Cette zone 403 dopée P peut être réalisée sur la fine couche semi-conductrice 402, qui peut être quant à elle non dopée ou à base d'un matériau semi-conducteur intrinsèque (figure 9A).

Les fines couches isolantes 301, 401 peuvent être par exemple à base de $SiO_2$ et prévues avec une épaisseur par exemple inférieure ou égale à 25 nanomètres ou inférieure ou égale à 10 nanomètres. Les fine couches semiconductrices 302, 402 peuvent quant à elle être prévues avec une épaisseur comprise par exemple entre 2 nm et 100 nm, par exemple de l'ordre de 10 nanomètres.

Les transistors NMOS $T_{11}$, $T_{12}$, $T_{13}$, $T_{14}$ sur le premier substrat et les transistors PMOS $T_{21}$, $T_{22}$, $T_{23}$, $T_{24}$ sur le deuxième substrat peuvent avoir été formés en technologie UTBB (UTBB pour « Ultra Thin Body and Box »).

Sur le premier substrat et sur le deuxième substrat, un ou plusieurs niveaux métalliques d'interconnexion 315 et 415 des transistors peuvent être ensuite formés dans au moins une couche isolante 317 et 417 ou dans un empilement de couches isolantes surmontant les transistors (figures 8A et 9A).

Ensuite, on forme des couches poignée 320 et 420 respectivement sur la ou les couche(s) isolante(s) recouvrant le premier substrat et le deuxième substrat. Ces couches poignée 320 et 420 peuvent être par exemple à base d'un matériau polymère.

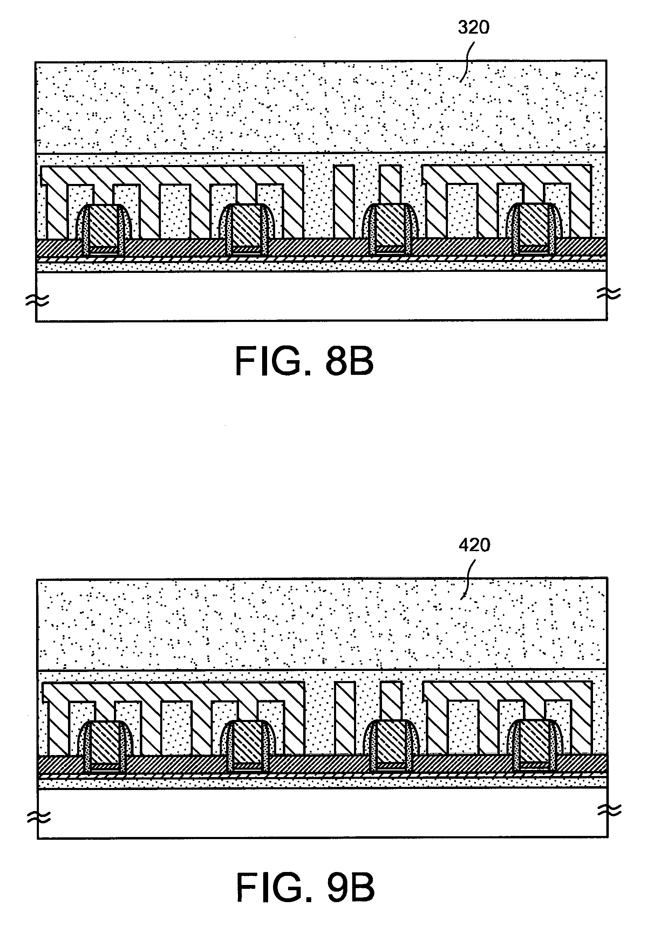

Les couches poignée 320, 420 favorisent une préhension des circuits en cours de réalisation et pourront jouer le rôle de support temporaire. Les couches poignée 320, 420 peuvent être éventuellement formées par collage moléculaire d'une plaque sur le dessus des circuits en cours de réalisation (figures 8B, 9B).

Ensuite, on retire du premier substrat et du deuxième substrat leurs couches de support 300 et 400 sacrificielles respectives ainsi que les couches isolantes 301 et 401.

Le retrait des couches de support 300 et 400 peut être réalisé par exemple par un procédé de polissage communément appelé de « grinding » ou rodage, et une gravure chimique par exemple à base de TMAH (TMAH pour « tetra-methyl ammonium hydroxide ») en particulier lorsque les couches de support 300, 400 sont à base de Si, un arrêt étant réalisé respectivement sur la couche isolante 301 et la couche isolante 401. Les couche isolantes 301, 401, sont ensuite retirées par exemple à l'aide de HF.

A l'issue de ce retrait, la fine couche semi-conductrice 302 du premier substrat et la fine couche semi-conductrice 402 du deuxième substrat sont dévoilées.

Ensuite, on peut éventuellement former sur les fines couches semi-conductrices 302, 402, par exemple par croissance, un matériau semi-conducteur à gap direct et/ou un matériau semi-conducteur à gap plus petit que celui des couches 302 et 402.

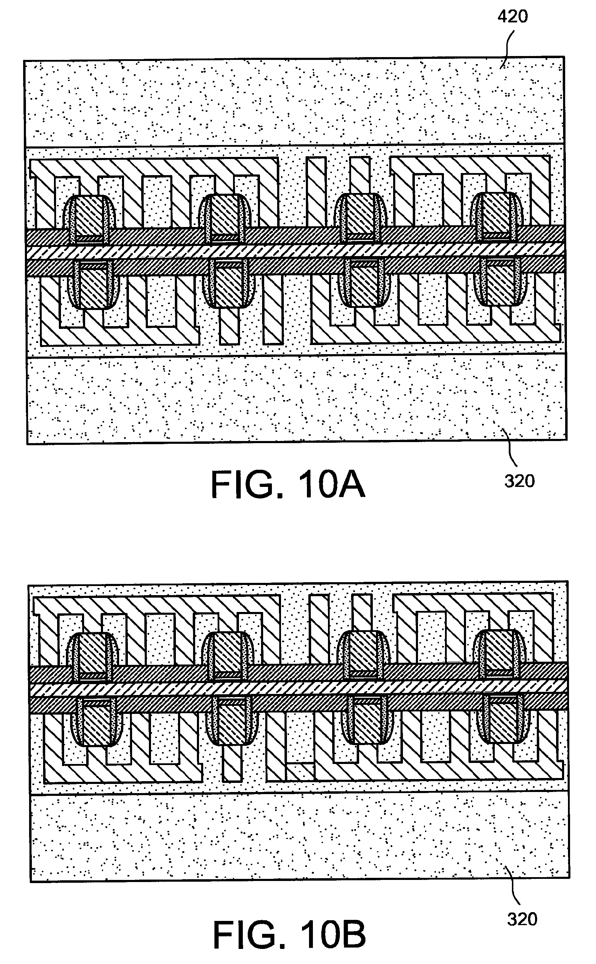

On effectue ensuite un collage des deux substrats en plaçant l'une contre l'autre les fines couches 302, 402 ou les matériaux semi-conducteurs formés respectivement sur ces dernières (figure 10A).

Puis, on réalise un retrait d'une des couches poignée 320, 420, tout en conservant l'autre couche poignée. Par exemple, ce peut être la couche poignée 420 formée sur le deuxième substrat qui est retirée tandis que la couche poignée 320 du premier substrat est conservée (figure 10B).

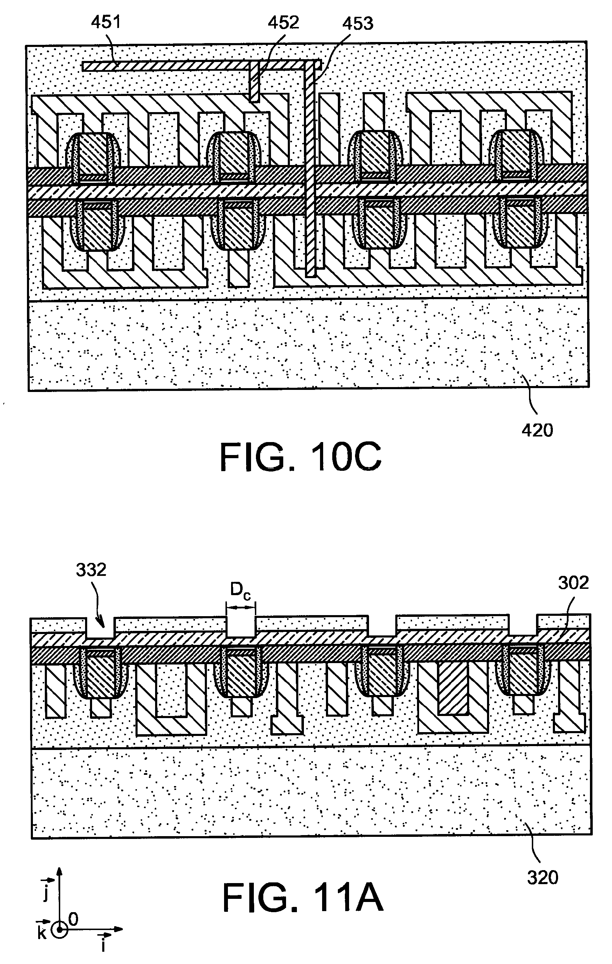

Ensuite, on peut former des connexions, par exemple sous forme d'au moins une ligne métallique 451 et vias 452, 453 entre un ou plusieurs transistors parmi les transistors PMOS $T_{21}$, $T_{22}$, $T_{23}$, $T_{24}$, et un ou plusieurs transistors NMOS parmi les transistors $T_{11}$, $T_{12}$, $T_{13}$, $T_{14}$ (figure 10C).

Une variante de procédé de réalisation est illustrée sur les figures 11A-11C. Cette variante permet par exemple de mettre en oeuvre un dispositif du type de celui illustré sur la figure 7.

Pour cet exemple de procédé, on réalise tout d'abord des étapes telles que décrites précédemment en liaison avec les figures 8A-8B.

Après avoir formé les couches poignée 320 et 420, on retire d'un des deux substrats, par exemple du premier substrat, sa couche de support 300 sacrificielle.

Puis, dans le cas où c'est le premier substrat dont on a retiré la couche de support 300, on réalise dans la couche isolante 301 de ce substrat des ouvertures 332 en regard des transistors $T_{11}$, $T_{12}$, $T_{13}$, $T_{14}$, de manière à dévoiler respectivement la fine couche semi-conductrice 302.

Les ouvertures 332 peuvent avoir une dimension appelée dimension critique Dc ou diamètre Dc de l'ordre de celui de la longueur de canal des transistors $T_{11}$, $T_{12}$, $T_{13}$, $T_{14}$, (la dimension critique Dc étant mesurée dans une direction parallèle au vecteur $\vec{i}$ du repère orthogonal [O; $\vec{i}$; $\vec{j}$; $\vec{k}$] donné sur la figure 11A).

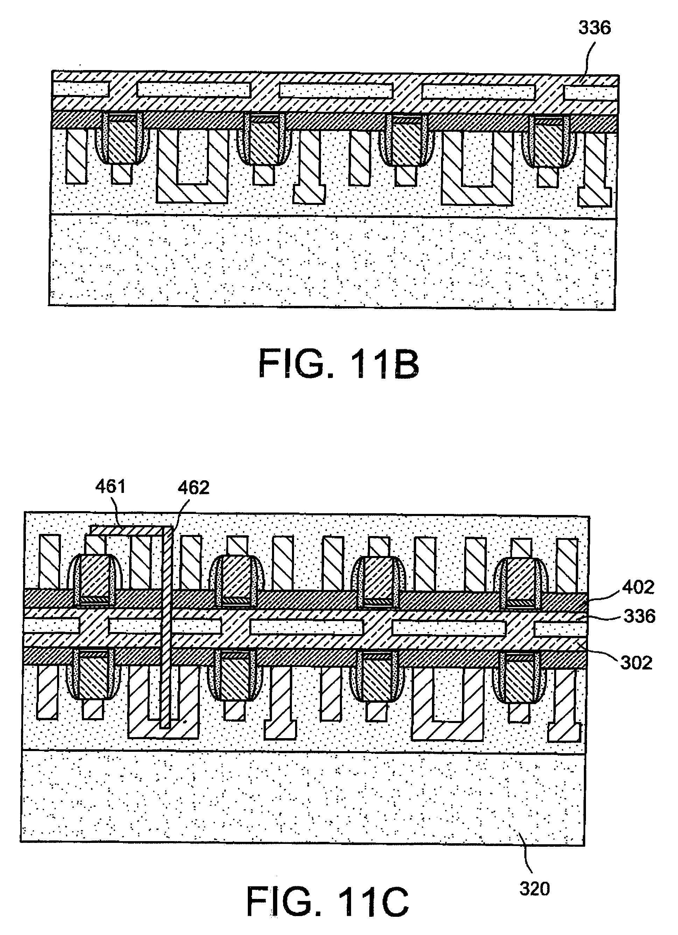

On peut ensuite réaliser une croissance d'au moins un matériau semi-conducteur 336 ou d'un empilement de matériaux semi-conducteurs 336 par épitaxie à travers les ouvertures 332, de manière à combler ces dernières et former une épaisseur de matériau semi-conducteur 336 reposant sur la fine couche semi-conductrice et sur la couche isolante 301 (figure 11B).

Sur l'autre substrat, on réalise un retrait de la couche de support 400 ainsi que de la couche isolante 401.

On effectue ensuite un collage des deux substrats en plaçant la fine couche semi-conductrice 402 contre l'empilement ou la couche de matériau(x) semi-conducteur(s) 336 formé(s) par épitaxie.

Puis, on réalise un retrait d'une des couches poignée 320, 420, tout en conservant l'autre couche poignée. Par exemple, ce peut être la couche poignée 420 formée sur le deuxième substrat qui peut être retirée.

Ensuite, on peut former des connexions, par exemple sous forme d'au moins une ligne métallique horizontale 461 et d'une ligne métallique verticale 462 permettant de connecter un ou plusieurs transistors parmi les transistors PMOS $T_{21}$, $T_{22}$, $T_{23}$, $T_{24}$, à un ou plusieurs des transistors NMOS parmi les transistors $T_{11}$, $T_{12}$, $T_{13}$, $T_{14}$ (figure 11C).

Avec l'un ou l'autre des exemples de procédé qui viennent d'être décrits, les transistors $T_{11}$, $T_{12}$, $T_{13}$, $T_{14}$ et $T_{21}$, $T_{22}$, $T_{23}$, $T_{24}$ sont formés de manière indépendante, ce qui permet notamment de mettre en oeuvre des transistors en regard les uns des autres sans avoir de limitation en termes de budget thermique nécessaire au procédé de fabrication.

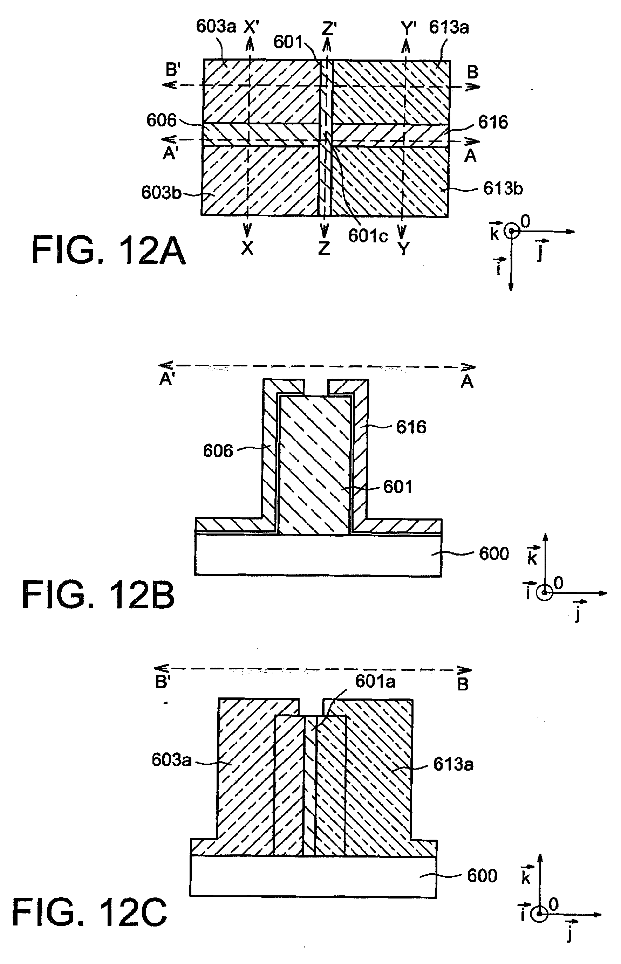

Une variante de réalisation d'un dispositif microélectronique émetteur de rayonnement lumineux suivant l'invention est donnée sur les figures 12A-12C (le dispositif étant représenté en vue de dessus sur la figure 12A et selon des vues en coupes transversales B'B et A'A respectivement sur les figures 12B et 12C).

Le dispositif comprend une zone semi-conductrice 601 de canal sous forme d'un bloc semi-conducteur communément appelé « fin » reposant sur un substrat 600 qui peut être par exemple un substrat semi-conducteur massif (« bulk » selon la terminologie anglo-saxonne) ou un substrat de type semi-conducteur sur isolant tel qu'un substrat SOI (SOI pour « silicon on insulator »).

Un premier transistor de type N doté d'une zone active 603 dopée N dans laquelle une région de source 603a et une région de drain 603b sont formées, et un deuxième transistor de type P doté d'une zone active 613 dopée P dans laquelle une région de source 613a et une région de drain 613b sont formées, partagent la zone semi-conductrice 601 dans laquelle une zone de canal est réalisée. La zone semi-conductrice 601 peut être à base d'un matériau semi-conducteur intrinsèque. Ainsi, les zones actives 603 et 613 ainsi que la zone 601 forment une jonction PIN.

Les zones de source 603a et de drain 603b du premier transistor sont respectivement en regard d'une zone de source 613a et de drain 613b du deuxième transistor.

Les zones de source 603a, 613a et de drain 603b, 613b du premier transistor et du deuxième transistor sont en particulier agencées de sorte qu'un axe X'X passant par les zones 603a, 603b de source et de drain du premier transistor, est parallèle à un autre axe Y'Y, passant par les zones de source 613a et de drain 613b du deuxième transistor, les axes X'X et Y'Y étant également parallèles et coplanaires avec un axe Z'Z passant par le bloc semi-conductreur 601.

Avec une telle disposition des zones de source et de drain, le flux de porteurs de charges pris dans la région 601c du bloc semi-conducteur 601 et circulant entre la zone de source 603a et de drain 63b du premier transistor, a une même direction ou une direction parallèle à celle du flux de porteurs de charges pris dans la région 601c et circulant entre la zone de source 613a et de drain 613b du deuxième transistor. La mise en oeuvre de flux de porteurs de charges de même direction permet d'améliorer les recombinaisons et donc l'efficacité d'émission de photons.

Selon une possibilité de mise en oeuvre, la zone semi-conductrice 601, et en particulier une région 601c de cette zone 601 située entre les grilles 606 et 616 des transistors $T_1$ et $T_2$ peut être formée d'un matériau semi-conducteur à gap direct.

Dans ce cas, la zone semi-conductrice 601 peut avoir été réalisée par exemple par gravure d'un bloc semi-conducteur puis par remplissage de zones supprimées par cette gravure à base d'un matériau semi-conducteur à gap direct.

## Revendications

1. Dispositif microélectronique émetteur de rayonnement lumineux comprenant au moins un premier transistor ($T_1$) doté de zones de source (103a, 603a) et de drain (103b, 603b) formées dans au moins une première zone (103) semi-conductrice dopée N et d'une grille (106, 606), au moins un deuxième transistor ($T_2$) doté de zones de source (113a, 613a) et de drain (113b, 613b) formées dans au moins une deuxième zone (113) semi-conductrice dopée P et d'une grille, la grille du premier transistor et la grille du deuxième transistor étant disposées en regard l'une de l'autre, de part et d'autre d'une zone (101, 601) comprenant une région donnée à base d'au moins un matériau semi-conducteur intrinsèque ou non-dopé, les zones de source (103a, 113a, 603a, 613a) et de drain (103b, 113b, 603b, 613b) du premier transistor et du deuxième transistor étant agencées de sorte qu'un premier axe (X'X) passant par les zones (603a, 603b) de source et de drain du premier transistor, un deuxième axe (Y'Y), par passant par les zones de source (613a) et de drain (613b) du deuxième transistor, et un troisième axe passant par ladite région donnée sont coplanaires, **caractérisé en ce que** le premier axe, le deuxième axe, et le troisième axe sont parallèles entre eux.

2. Dispositif microélectronique selon la revendication 1, la grille du premier transistor et la grille du deuxième transistor étant disposées tête bêche.

3. Dispositif microélectronique selon la revendication 2, dans lequel les zones (103a, 603a, 103b, 603b) de source et de drain du premier transistor sont situées dans un premier plan contenant ledit premier axe (X'X), les zones (113a, 613b, 113b, 613b) de source et de drain du deuxième transistor sont situées dans un deuxième plan, le deuxième plan contenant ledit deuxième axe (Y'Y) et étant distinct dudit premier plan et parallèle audit premier plan, une zone de source du premier transistor étant disposée en regard d'une zone de source ou de drain du deuxième transistor.

4. Dispositif microélectronique selon la revendication 2, dans lequel les zones de source (103a, 603a) et de drain (103b, 603b) du premier transistor sont situées dans un même plan que les zones (113a, 613b, 113b, 613b) de source et de drain du deuxième transistor.

5. Dispositif microélectronique suivant l'une des revendications 1 à 4, dans lequel la zone de source (103a) du premier transistor ($T_1$) est disposée en regard de la zone (113a) de source du deuxième transistor ($T_2$), la zone de drain

(103b) du premier transistor étant disposée en regard de la zone de drain du deuxième transistor ($T_2$).

6. Dispositif microélectronique suivant l'une des revendications 1 à 5, le premier transistor et le deuxième transistor étant symétriques par rapport à un plan passant par ladite région donnée (101).

7. Dispositif microélectronique suivant l'une des revendications 1 à 6, dans lequel la zone de source (103a) du premier transistor ($T_1$) est en regard et séparée d'une zone (113a) de source ou de drain du deuxième transistor ($T_2$) par au moins une zone isolante (131a), la zone de drain (103b) du premier transistor étant en regard et séparée d'une zone (113b) de source ou de drain du deuxième transistor ($T_2$) par au moins une autre zone isolante (131b).

8. Dispositif microélectronique suivant l'une des revendications 1 à 7, ladite région donnée ayant une épaisseur comprise entre 2 nm et 100 nm.

9. Dispositif microélectronique suivant l'une des revendications 1 à 7, dans lequel ladite région donnée (101c) semi-conductrice comprend un matériau à gap direct.

10. Dispositif microélectronique suivant l'une des revendications 1 à 9, dans lequel ladite région donnée est formée d'une hétéro-structure comportant un empilement d'au moins un premier matériau semi-conducteur, d'au moins un deuxième matériau semi-conducteur de gap différent de celui du premier matériau semi-conducteur ou d'un empilement formé d'au moins un premier matériau semi-conducteur, d'au moins un deuxième matériau semi-conducteur et d'au moins un troisième matériau semi-conducteur, le deuxième matériau semi-conducteur étant situé entre le premier matériau semi-conducteur et le troisième matériau semi-conducteur et ayant un gap plus faible que celui desdits premier matériau semi-conducteur et troisième matériau semi-conducteur.

11. Procédé de réalisation d'un dispositif microélectronique émetteur de rayonnement lumineux comprenant, des étapes de :

   - réalisation d'au moins un premier transistor ($T_{11}$, $T_{12}$, $T_{13}$, $T_{14}$) reposant sur un premier substrat, le premier substrat comprenant une couche de support (300), une couche isolante (301) et une fine couche semi-conductrice (302), le premier transistor étant doté de zones de source (103a) et de drain (103b) formées dans au moins une première zone (103) semi-conductrice dopée N et d'une grille (106),
   - formation d'au moins un deuxième transistor ($T_{21}$, $T_{22}$, $T_{23}$, $T_{24}$) reposant sur un deuxième substrat, le deuxième substrat comprenant une couche de support (400), une couche isolante (401), et une fine couche semi-conductrice (402), le deuxième transistor ($T_2$) étant doté de zones de source et de drain formées dans au moins une deuxième zone (113) semi-conductrice dopée P et d'une grille,
   - retrait de la couche de support (300 ou 400) et de ladite couche isolante (301 ou 401) d'un substrat donné parmi le premier substrat et le deuxième substrat,
   - retrait de la couche de support (400 ou 300) et d'au moins une portion donnée de la couche isolante (401 ou 301) de l'autre substrat parmi le premier substrat et le deuxième substrat, ladite portion donnée étant retirée de manière à dévoiler la fine couche semi-conductrice (302 ou 402) en regard d'une grille d'un transistor donné parmi ledit premier transistor et le deuxième transistor,
   - assemblage de la fine couche semi-conductrice (302 ou 402) dudit substrat donné avec ladite fine couche semi-conductrice (402 ou 302) dudit autre substrat ou avec un matériau semi-conducteur donné (336) formé sur ladite fine couche semi-conductrice dudit autre substrat, le premier transistor ($T_{11}$, $T_{12}$, $T_{13}$, $T_{14}$) étant placé en regard du deuxième transistor ($T_{21}$, $T_{22}$, $T_{23}$, $T_{24}$).

12. Procédé selon la revendication 11, dans lequel le retrait de ladite portion donnée est effectué de manière à former une ouverture (332) dans la couche isolante dévoilant la fine couche semi-conductrice en regard d'une grille d'un transistor donné parmi ledit premier transistor et le deuxième transistor, le procédé comprenant, préalablement à l'étape de retrait de la couche de support (300 ou 400) et de ladite couche isolante (301 ou 401) d'un substrat donné parmi le premier substrat et le deuxième substrat, la croissance dudit matériau semi-conducteur donné (336) sur ladite fine couche semi-conductrice dudit autre substrat de manière à recouvrir la couche isolante dudit autre substrat

13. Procédé selon la revendication 11 ou 12, ledit matériau semi-conducteur donné (336) est un matériau à gap direct et/ou étant un matériau ayant un gap plus faible que le matériau de ladite fine couche semi-conductrice du premier substrat et du matériau de la fine couche semi-conductrice du deuxième substrat.

**Patentansprüche**

1. Lichtstrahlenemittierende mikroelektronische Vorrichtung, welche zumindest einen ersten Transistor ($T_1$), welcher Source-Zonen (103a, 603a) und Drain-Zonen (103b, 603b), welche auf zumindest einer ersten N-dotierten Halbleiterzone (103) ausgebildet sind, sowie ein Gate (106, 606) aufweist, zumindest einen zweiten Transistor ($T_2$), welcher Source-Zonen (113a, 613a) und Drain-Bereiche (113b, 613b), welche auf zumindest einer zweiten P-dotierten Halbleiterzone (113) ausgebildet sind, sowie ein Gate aufweist, wobei das Gate des ersten Transistors und das Gate des zweiten Transistors einander gegenüber angeordnet sind, wobei auf beiden Seiten einer Zone (101, 601), welche eine bestimmte Zone auf der Basis zumindest eines inhärenten oder undotierten Halbleiterwerkstoff aufweist, die Source-Zonen (103a, 113a, 603a, 613a) und die Drain-Zonen (103b, 113b, 603b, 613b) des ersten Transistors und des zweiten Transistors derart angeordnet sind, dass eine erste Achse (X', X), welche durch die Source- und Drain-Zonen (603a, 603b) des ersten Transistors verläuft, eine zweite Achse (Y', Y), welche durch die Source-Zone (613a) und die Drain-Zone (613b) des zweiten Transistors verläuft, und eine dritte Achse, welche durch die bestimmte Zone verläuft, koplanar sind, **dadurch gekennzeichnet, dass** die erste Achse, die zweite Achse und die dritte Achse parallel zueinander sind.

2. Mikroelektronische Vorrichtung nach Anspruch 1, wobei das Gate des ersten Transistors und das Gate des zweiten Transistors entgegengesetzt angeordnet sind.

3. Mikroeleketronische Vorrichtung nach Anspruch 2, in welcher die Source- und Drainzonen (1 03a, 603a, 103b, 603b) des ersten Transistors in einer ersten Ebene liegen, welche die erste Achse (X', X) umfasst, die Source- und Drainzonen (113a, 613a, 113b, 613b) des zweiten Transistors in einer zweiten Ebene liegen, wobei die zweite Ebene die besagte zweite Achse (Y', Y) umfasst und von der ersten Ebene getrennt und parallel zu dieser ersten Ebene angeordnet ist, wobei eine Source-Zone des ersten Transistors gegenüber einer Source- oder Drain-Zone des zweiten Transistors angeordnet ist.

4. Mikroelektronische Vorrichtung nach Anspruch 2, in welcher die Source-Zonen (1 03a, 603a) und die Drain-Zonen (103b, 603b) des ersten Transistors in einer gleichen Ebene angeordnet sind wie die Source- und Drain-Zonen (113a, 613b, 113b, 613b) des zweiten Transistors.

5. Mikroelektronische Vorrichtung nach einem der Ansprüche 1 bis 4, in welcher die Source-Zone (1 03a) des ersten Transistors ($T_1$) gegenüber der Source-Zone (113a) des zweiten Transistors ($T_2$) angeordnet ist, wobei die Drain-Zone (1 03b) des ersten Transistors gegenüber der Drain-Zone des zweiten Transistors ($T_2$) angeordnet ist.

6. Mikroelektronische Vorrichtung nach einem der Ansprüche 1 bis 5, wobei der erste Transistor und der zweite Transistor zu einer die bestimmte Zone (101) durchlaufenden Ebene symmetrisch sind.

7. Mikroelektronische Vorrichtung nach einem der Ansprüche 1 bis 6, in welcher die Source-Zone (1 03a) des ersten Transistors ($T_1$) gegenüber und durch mindestens eine Isolierschicht (131a) von einer Source-oder Drain-Zone (113a) des zweiten Transistors ($T_2$) getrennt angeordnet ist, wobei die Drain-Zone (1 03b) des ersten Transistors gegenüber und durch mindestens eine zweite Isolierschicht (131 b) von einer Source- oder Drain-Zone (113b) des zweiten Transistors ($T_2$) getrennt angeordnet ist.

8. Mikroeleketronische Vorrichtung nach einem der Ansprüche 1 bis 7, wobei die bestimmte Zone eine Dicke zwischen 2 nm und 100 nm aufweist.

9. Mikroelektronische Vorrichtung nach einem der Ansprüche 1 bis 7, in welcher die bestimmte halbleitende Zone (101 c) einen Werkstoff mit direkter Bandlücke aufweist.

10. Mikroelektronische Vorrichtung nach einem der Ansprüche 1 bis 9, in welcher die bestimmte Zone aus einer Heterostruktur gebildet ist, welche eine Stapelung zumindest eines ersten Halbleiterwerkstoffs und zumindest eines zweiten Halbleiterwerkstoffs mit anderer Bandlücke als der erste Halbleiterwerkstoff aufweist, oder einer Stapelung aufweist, welche aus zumindest einem ersten Halbleiterwerkstoff, zumindest einem zweiten Halbleiterwerkstoff und zumindest einem dritten Halbleiterwerkstoff gebildet ist, wobei der zweite Halbleiterwerkstoff zwischen dem ersten Halbleiterwerkstoff und dem dritten Halbleiterwerkstoff angeordnet ist und eine geringere Bandlücke als der erste Halbleiterwerkstoff und der dritte Halbleiterwerkstoff aufweist.

11. Verfahren zur Herstellung einer lichtstrahlenemittierenden mikroelektronischen Vorrichtung, welches die folgenden Schritte umfasst:

Herstellung zumindest eines ersten Transistors ($T_{11}$, $T_{12}$, $T_{13}$, $T_{14}$), welcher auf einem ersten Substrat liegt, wobei das erste Substrat eine Trägerschicht (300), eine Isolierschicht (301) und eine dünne halbleitende Schicht (302) umfasst, wobei der erste Transistor eine Source-Zone (103a) und eine Drain-Zone (103b) aufweist, welche in zumindest einer ersten N-dotierten halbleitenden Zone (103) ausgebildet sind, sowie ein Gate (106) aufweist; Bildung zumindest eines zweiten Transistors ($T_{21}$, $T_{22}$, $T_{23}$, $T_{24}$), welcher auf einem zweiten Substrat liegt, wobei das zweite Substrat eine Trägerschicht (400), eine Isolierschicht (401) und eine dünne halbleitende Schicht (402) umfasst, wobei der zweite Transistor ($T_2$) eine Source-Zone und eine Drain-Zone, welche in zumindest einer zweiten P-dotierten halbleitenden Zone (113) ausgebildet sind, sowie ein Gate aufweist; Entfernen der Trägerschicht (300 oder 400) und der Isolierschicht (301 oder 401) von einem bestimmten ersten oder zweiten Substrat; Entfernen der Trägerschicht (400 oder 300) und zumindest eines bestimmten Abschnitts der Isolierschicht (401 oder 301) von dem anderen ersten oder zweiten Substrat, wobei der bestimmte Abschnitt derart enfernt wird, dass die dünne halbleitende Schicht (302 oder 402) gegenüber einem Gate eines bestimmten ersten oder zweiten Transistors freigelegt wird; Verbinden bzw. Zusammenfügen der dünnen halbleitenden Schicht (302 oder 402) des bestimmten Substrats mit der dünnen halbleitenden Schicht (402 oder 302) des anderen Substrats oder mit einem bestimmten halbleitenden Werkstoff (336), welcher auf der dünnen halbleitenden Schicht des andren Substrats ausgebildet ist, wobei der erste Transistor ($T_{11}$, $T_{12}$, $T_{13}$, $T_{14}$) gegenüber dem zweiten Transistor ($T_{21}$, $T_{22}$, $T_{23}$, $T_{24}$) angeordnet ist.

12. Verfahren nach Anspruch 11, bei welchem das Entfernen des bestimmten Abschnitts so erfolgt, dass eine Öffnung (332) in der Isolierschicht gebildet wird, welche die dünne halbleitende Schicht gegenüber einem Gate des bestimmten ersten oder zweiten Transistors freilegt, wobei das Verfahren vor dem Schritt des Entfernens der Trägerschicht (300 oder 400) und der Isolierschicht (301 oder 401) von einem bestimmten ersten oder zweiten Substrat die Züchtung des bestimmten halbleitenden Werkstoffs (336) auf der dünnen halbleitenden Schicht des anderen Substrats aufweist, so dass die Isolierschicht des anderen Substrats bedeckt ist.

13. Verfahren nach Anspruch 11 oder 12, wobei der bestimmte halbleitende Werkstoff (336) ein Werkstoff mit direkter Bandlücke ist und/oder ein Werkstoff ist, welcher eine geringere Bandlücke aufweist als der Werkstoff der besagten dünnen halbleitenden Schicht des ersten Substrats und des Werkstoffs der dünnen halbleitenden Schicht des zweiten Substrats.

**Claims**

1. A light-emitting microelectronic device including at least a first transistor ($T_1$) having source (103a, 603a) and drain regions (103b, 603b) formed in at least a first N-doped semiconductor region (103) and a gate (106, 606), at least a second transistor ($T_2$) having source (113a, 613a) and drain (113b, 613b) regions formed in at least a second P-doped semiconductor region (113) and a gate, where the gate of the first transistor and the gate of the second transistor are positioned opposite one another, either side of a region (101, 601) including a given region made of at least one intrinsic or undoped semiconductor material, where the source (103a, 603a, 113a, 613a) and drain regions (103b, 603b, 113b, 613b) of the first transistor and of the second transistor are designed such that a first axis (X'X) passing through the source and drain regions of the first transistor, a second axis (Y'Y), passing through the source and drain regions of the second transistor, and a third axis passing through said given region are coplanar, **characterized in that** first axis, second axis and third axis are parallel.

2. A microelectronic device according to claim 1, where the gate of the first transistor and the gate of the second transistor are positioned head-to-tail.

3. A microelectronic device according to claim 2, wherein the source and drain regions (103a, 603a, 103b, 603b) of the first transistor are located in a first plane containing said first axis (X'X), where the source and drain regions (113a, 613a, 113b, 613b) of the second transistor are located in a second plane, where the second plane contains said second axis (Y'Y), and is separate from said first plane and parallel to said first plane, and where a source region of the first transistor is positioned opposite a source or drain region of the second transistor.

4. A microelectronic device according to claim 2, wherein the source (103a, 603a) and drain (103b, 603b) regions of the first transistor are located in the same plane as the source and drain regions (113a, 613a, 113b, 613b) of the second transistor.

5. A microelectronic device according to any of claims 1 to 4, wherein the source region (103a) of the first transistor ($T_1$) is positioned opposite the source region (113a) of the second transistor ($T_2$), where the drain region (103b) of the first transistor is positioned opposite the drain region of the second transistor ($T_2$).

6. A microelectronic device according to any of claims 1 to 5, wherein the first transistor and the second transistor are symmetrical relative to a plane passing through said given region (101).

7. A microelectronic device according to any of claims 1 to 6, wherein the source region (103a) of the first transistor ($T_1$) is opposite and separated from a source (113a) or drain region of the second transistor ($T_2$) by at least one insulating region (131a), wherein the drain region (103b) of the first transistor is opposite and separated from a source or drain region (113b) of the second transistor by at least one other insulating region (131b).

8. A microelectronic device according to any of claims 1 to 7, wherein said given region is between 2 nm and 100 nm thick.

9. A microelectronic device according to any of claims 1 to 7, wherein said given semiconductor region includes a direct-gap material.

10. A microelectronic device according to any of claims 1 to 9, wherein said given region is formed from a hetero-structure including a stack of at least one first semiconductor material, of at least one second semiconductor material having a different gap to that of the first semiconductor material, or from a stack formed from at least one first semiconductor material, from at least one second semiconductor material, and from at least one third semiconductor material, where the second semiconductor material is located between the first semiconductor material and the third semiconductor material, and has a gap which is smaller than that of said first and third semiconductor materials.

11. A method of production of a light-emitting microelectronic device including steps of:

- production of at least one first transistor ($T_{11}$, $T_{12}$, $T_{13}$, $T_{14}$) resting on a first substrate, where the first substrate includes a support layer (300), an insulating layer (301) and a thin semiconductor layer (302), where the first transistor has source (103a) and drain (103b) regions formed in at least one N-doped semiconductor region (103), and one gate (106),
- formation of at least one second transistor ($T_{21}$, $T_{22}$, $T_{23}$, $T_{24}$) resting on a second substrate, where the second substrate includes a support layer (400), an insulating layer (401) and a thin semiconductor layer (402), where the second transistor ($T_2$) has source and drain regions formed in at least one P-doped semiconductor region, and one gate,
- removal of the support layer (300 or 400) and of said insulating layer (301 or 401) of a given substrate which is either the first substrate or the second substrate,
- removal of the support layer (400 or 300) of at least one given portion of the insulating layer (401 or 301) of the other substrate, which is either the first substrate or the second substrate, where said given portion is removed so as to reveal the thin semiconductor layer (302 or 402) opposite a gate of a given transistor which is either said first transistor or the second transistor,
- assembly of the thin semiconductor layer (302 or 402) of said given substrate with said thin semiconductor layer (302 or 402) of said other substrate, or with a given semiconductor material (336) formed on said thin semiconductor layer of said other substrate, where the first transistor ($T_{11}$, $T_{12}$, $T_{13}$, $T_{14}$) is positioned opposite the second transistor ($T_{21}$, $T_{22}$, $T_{23}$, $T2_4$).

12. A method according to claim 11, in which the removal of said given portion is accomplished so as to form an aperture (332) in the insulating layer revealing the thin semiconductor layer opposite a gate of a given transistor which is either said first transistor or the second transistor, where the method includes, prior to step of removal of the support layer (300 or 400) and of said insulating layer (301 or 401) of a given substrate, growth of said given semiconductor material (336) on said thin semiconductor layer of the other said substrate, so as to cover the insulating layer of said other substrate.

13. A method according to claim 11 or 12, where said given semiconductor material (336) is a direct-gap material and/or is a material having a smaller gap than the material of said thin semiconductor layer of the first substrate and of the material of the thin semiconductor layer of the second substrate.

FIG. 1

FIG. 2A

FIG. 2B

# FIG. 2C

FIG. 3

FIG. 4

E (eV)

**FIG. 5**

**FIG. 6**

FIG. 7

FIG. 8A

FIG. 9A

320

## FIG. 8B

420

## FIG. 9B

302

320

FIG. 8C

402

420

FIG. 9C

420

## FIG. 10A

320

## FIG. 10B

320

451 452 453

**FIG. 10C**

420

332 $D_c$ 302

**FIG. 11A**

320

$\vec{j}$

$\vec{k}$ $\circ$ 0 $\vec{i}$

336

## FIG. 11B

461    462

402

336

302

320

## FIG. 11C

# FIG. 12A

# FIG. 12B

# FIG. 12C

**EP 2 592 663 B1**

## RÉFÉRENCES CITÉES DANS LA DESCRIPTION

**Documents brevets cités dans la description**

- US 7297589 B

- US 4905059 A